(19) Europäisches Patentamt
European Patent Office
Office européen des brevets

(11) Publication number: **0 174 638 B1**

(12) **EUROPEAN PATENT SPECIFICATION**

(45) Date of publication of patent specification: **01.04.92**

(51) Int. Cl.5: **G11C 7/00**, G11C 11/406

(21) Application number: **85111433.0**

(22) Date of filing: **10.09.85**

# (54) Integrated circuit with function of monitoring an internal signal.

(30) Priority: **10.09.84 JP 189107/84**

(43) Date of publication of application:
**19.03.86 Bulletin 86/12**

(45) Publication of the grant of the patent:
**01.04.92 Bulletin 92/14**

(84) Designated Contracting States:
**DE FR GB**

(56) References cited:
**US-A- 4 145 760**

**IEEE JOURNAL OF SOLID STATE CIRCUITS, vol. SC-16, no. 5, October 1981, pages 479-487, IEEE, New York, US; E.A. REESE et al.: "A 4K x 8 dynamic RAM with self-refresh"**

(73) Proprietor: **NEC CORPORATION**
**7-1, Shiba 5-chome Minato-ku**
**Tokyo 108-01(JP)**

(72) Inventor: **Watanabe, Hiroshi**
**c/o NEC Corporation 331, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**W-8000 München 26(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services

## Description

### BACKGROUND OF THE INVENTION

The present invention relates to integrated circuits and more particularly to integrated circuit memory devices having automatic refreshing function.

Integrated circuits have been widely used in various fields, and types of integrated circuits are very large in number.

In order to check functions of integrated circuits, it has been practised that relationship between inputs - outputs are observed. This technique is effective for integrated circuit having combination logic circuits such as AND NOR gates since an input to the integrated circuit and its relevant output therefrom can be obtained through a small elapse of time or almost at the same time: However, for integrated circuits having sequential logic circuits such as shift registers, and memory circuits, an output is obtained after a predetermined time has elapsed from the application of an input. Therefore, it has been difficult to check the function of such integrated circuits by observing input - output characteristics. This problem is very typical in an integrated circuit memory (IC memory) having an automatic or internal refreshing function in which a refresh operation for memory cells is internally performed repeatedly without receiving any refresh address information and refresh timing signals. The above type IC memory has a refresh timer circuit and an auto-refresh timing signal generator. When a refresh control signal applied to the refresh timer circuit from the outside is kept at an active level, the refresh timer circuit produces an internal refresh command signal intermittently and the auto-refresh timing signal generator produces a refresh timing signal for allowing an internal refresh operation in response to the internal command signal. In this memory, as long as the refresh control signal is kept active, refresh of memory cells is sequentially conducted without necessity of control from the outside.

Heretofore, a long period of time has been required to evaluate data-holding function of memory cells in such memory because a holding time of memory cells is generally 10 seconds or more and generally two to three times of the holding time is employed in evaluation in order to take the safety side. In this point of view, if it is possible to observe the internal signal for controlling refresh operation directly, evaluation of memories would be conducted effectively. However, the number of pins of such memories has been limited to a certain number, e.g. 16, according to the commercial specification or standard, and therefore there has been no allowance to provide an additonal pin for observing the internal signal.

### SUMMARY OF THE INVENTION

It is one object of the present invention to provide an improved integrated circuit with function of monitoring an internal signal.

It is another object of the present invention to provide a semiconductor memory device of self-refreshing type with an improved function of monitoring self refresh.

The integrated circuit according to the invention is defined in claim 1.

### BRIEF DESCRIPTION OF THE DRAWINGS

Fig. 1 is a schematic block diagram showing a first embodiment of the invention;

Fig. 2 is a diagram showing operation of the embodiment of Fig. 1;

Fig. 3 is a schematic circuit diagram showing second embodiment of the invention; and

Fig. 4 is a schematic circuit diagram showing third embodiment.

### DETAILED DESCRIPTION OF THE INVENTION

Referring to Fig. 1, a dynamic memory to which the present invention is applied is described.

The memory device formed on a semiconductor chip 1 includes a memory cell matrix 101 of dynamic type memory cells arranged in rows and columns, a circuit block 102 of sense amplifiers and data I/O gates. The memory is known multi-addressing type in which row address signals and column address signals are taken in via set of address input terminals $A_1$ to $A_n$ in response to active levels of a row address strobe $\overline{RAS}$ and a column address strobe $\overline{CAS}$, respectively. A RAS input buffer control logic circuit 114 receives $\overline{RAS}$ and drives a $\overline{RAS}$ clock generator 115 which generates a timing signal $\phi_L$ for enabling a row address inverter buffer 118, a timing signal $\phi_D$ for enabling a row decoder 116 to select one of rows of the matrix 101 and a timing signal $\phi_D$ for enabling sense amplifiers to refresh contents of the memory cells on the selected row. A $\overline{CAS}$ clock generator 108 receives $\overline{CAS}$ and the timing signal $\phi_R$ and generates a timing signal $\phi_C$ for enabling a column address inverter buffer 104, a column decoder 103, data I/O gates, a write clock generator 107, a data input buffer 106 and a data output buffer 105, in a known predetermined sequence. Although the signal $\phi_C$ is representatively illustrated as a single timing signal, a plurality of sequential signals are employed for the above blocks 104, 103, 107, 106 and 105 in practice case. In order to conduct internal refresh operations which are performed without receiving any address signals, $\overline{RAS}$ and $\overline{CAS}$, the memory is provided with a refresh control timer 109, an auto refreshing timing generator 112, a refresh address counter 113 and a multiplexer 117. The refresh timer 109 receives a refresh control signal $\overline{RFSH}$ , and generates control signals $R_1$ to $R_3$ when $\overline{RFSH}$ is kept at a low level, thereby to introduce an internal refresh mode to the memory. In this instance, the control signal $R_1$ controls the multiplexer 117 so that the multiplexer connects parallel outputs RC of the address counter 113 to the row decoder 116 in place of the output of the row address inverter buffer 118. The control signal $R_2$ enables the auto refresh timing generator 112 so that the generator 112 produces a refresh timing signal $\phi_{Ra}$ at the beginning of each refresh cycle which is applied to the RAS input buffer control logic circuit 114 and a refresh address incrementing signal $\phi_{Rb}$ which is applied to the refresh address counter 113 thereby to increment the content of the counter 113. In response to the signal $\phi_{Ra}$, the circuit 114 controls the $\overline{RAS}$ clock generator 115 so that the generator 115 generates the timing signals $\phi_L$, $\phi_D$ and $\phi_R$. Thus, the row decoder 116 selects one of rows of the matrix 101 based on the content of the refresh address counter 113 and the sense amplifiers 102 are enabled in response to the timing signal $\phi_R$ thereby to refresh the memory cells on the selected row. Thereafter, the address content of the address counter 113 in response to the signal $\phi_{Rb}$. The above sequence of operations are repeated as long as the $\overline{RFSH}$ is kept at a low level. The further detailed feature of this memory is disclosed in United States Patent Specification No. 4,334,295 issued to Nagami.

In this memory, it is important to detect the cycle time of internal refresh operation in order to evaluate data holding function of the memory.

In this point of view, a refresh detecting circuit 10 is provided on the semiconductor chip 1 according to the present invention. The refresh detection circuit 10 includes a field effect transistor $Q_{12}$ having a gate receiving the signal $\phi_R$ and a source coupled to a power voltage terminal $V_{CC}$ and a field effect transistor $Q_{11}$ having a gate and a drain commonly connected to a write control terminal $\overline{WE}$ which assumes a high level during a read cycle and a refresh cycle and a low level during a write cycle, and a source connected to a drain of the transistor $Q_{12}$.

Referring to Fig. 2, the internal refresh operations of the memory of Fig. 1 is explained.

$\overline{RFSH}$ is turned to a low (GND) level from a high level at a time point $t_1$, and the refresh timer 109 generates the signals $R_1$ and $R_2$ at a time point $t_2$ so that an internal refresh mode is introduced in the memory. In response to this, the timing generator 112 generates the signal $\phi_{Ra}$ at a time point $t_3$ so that the $\overline{RAS}$ clock generator 115 generates the signals $\phi_D$ and $\phi_R$ so that the output RC of the refresh address counter 113 drives the row decoder 116 so as to select one row of the matrix and contents of memory cells on the selected row are refreshed by the sense amplifiers. While, the terminal $\overline{WE}$ is raised to the voltage ($V_{CC}$ + $\alpha$) which is larger than the sum of the voltage $V_{CC}$ and a threshold voltage of the transistor $Q_{11}$, from $t_2$. In this instance, the memory does not operate in a write cycle, there is affection on a write clock generator 107. Accordingly, the transistor $Q_{11}$ assumes a conductive state so that a detection current Idet flows from the terminal $\overline{WE}$ to the voltage terminal in response to the activation of the signal $\phi_R$ substantially at $t_3$. After the refresh conducted by the signal $\phi_R$, the timing generator 112 generates the signal $\phi_{Rb}$ to increment the content of the refresh address counter 112 for preparation of a subsequent refresh cycle, at a time point $t_4$. After a refresh cycle period $T_F$ has elapsed from $t_3$, the timing generator 112 generates the signal $\phi_{RA}$ and the clock generator 115 generates the signals $\phi_D$ and $\phi_R$, so that memory cells on the different row are refreshed. As long as the $\overline{RFSH}$ is maintained at a low level, the above refresh cycle is repeatedly with a refresh cycle $T_F$ which is solely determined by the timing generator 112 and cannot be controlled from the outside. As illustrated, the above refresh cycle $T_F$ can be observed by the current Idet flowing through the terminal $\overline{WE}$ according to the invention.

In this embodiment, in place of applying the signal $\phi_R$ to the gate of the transistor $Q_{12}$, the signal $\phi_D$ or $\phi_{Ra}$ may be applied to the gate of the transistor $Q_{12}$. Also, instead of the terminal $\overline{WE}$, the gate and drain of the transistor $Q_{11}$ may be connected to other terminal which is not used in the refresh cycle.

Fig. 3. shows another embodiment of the refresh detecting circuit 10. In this embodiment, a field effect transistor $Q_{13}$ and a boot capacitor $C_{21}$ are further provided to the circuit 10 of Fig. 1. Namely, a drain-source path of the transistor $Q_{13}$ is coupled between the power voltage terminal $V_{CC}$ and the gate of the transistor $Q_{12}$ with a gate coupled to $V_{CC}$. The internal signal $\phi_R$ is applied to the gate of the transistor $Q_{12}$ via the capacitor $C_{21}$. When the internal signal $\phi_R$ is at a low level, the gate of $Q_{12}$ is at a potential of ($V_{CC}$ - $V_{TH}$) in which $V_{TH}$ is the threshold voltage of the transistor $Q_{13}$. Therefore, $Q_{12}$ assumes a non-conductive state. When the internal signal $\phi_R$ is turned to a high level, the gate of $Q_{12}$ is raised above ($V_{CC}$ + $V_{TH}$) by a known boot-strap effect, the transistor $Q_{12}$ assumes a conductive state. Therefore, when the voltage of ($V_{CC}+\alpha$) is applied to the terminal $\overline{WE}$, a

detection current Idet flows from the terminal $\overline{WE}$.

Fig. 4 shows a third embodiment of the invention. In this embodiment, diode-connected field effect transistors $Q_{21}$ to $Q_{23}$ are inserted in series between the source of the transistor $Q_{11}$ and the drain of the transistor $Q_{12}$. Furthermore, in place of the terminals $\overline{WE}$ and $V_{CC}$, two address input terminals $A_i$ and $A_j$ are connected to the transistors $Q_{11}$ and $Q_{12}$. In this embodiment, by applying a voltage more than the sum of threshold voltage of the transistor $Q_{11}$, $Q_{21}$ to $Q_{23}$ and $Q_{12}$ between the terminals $A_i$ and $A_j$, a detection of the internal signal $\phi_R$ is performed.

As described above, the detection of an internal signal is conducted effectively according to the invention. It should be noted that the present invention is not limited to the above embodiment. For example, the present invention applicable to integrated circuits other than memories.

## Claims

1. A semiconductor integrated circuit operable with a power voltage (Vcc) and a ground voltage (GND) and comprising a semiconductor chip (1), first (109, 112, 114, 115), second (102, 105) and third (106) circuit means formed on the semiconductor chip, a plurality of external terminals including a power voltage terminal receiving said power voltage (Vcc), a first input terminal receiving a first signal ($\overline{RESH}$), a second input terminal receiving a second signal ($\overline{WE}$) and an output terminal (DOUT), and fourth circuit means (107) responsive to said second signal ($\overline{WE}$) for controlling said second and third circuit means, said first circuit means receiving the first signal ($\overline{RESH}$) and generating an internal signal ($\phi_R$), said second circuit means receiving said internal signal and having an output end (DATA OUT) coupled to said output terminal, said fourth circuit means enabling said second circuit means and disenabling said third circuit means when a level of said second signal ($\overline{WE}$) is close to said power voltage and enabling said third circuit means and disenabling said second circuit means when the level of said second signal is close to said ground voltage, **characterized** in that said semiconductor integrated circuit further comprises a detection circuit (10) for detecting said internal signal, said detection circuit being coupled between said power voltage terminal (Vcc) and said second input terminal ($\overline{WE}$) and including a first transistor (Q12) having a control electrode, means for applying said internal signal to said control electrode, voltage switching means (Q11, Q21-Q23), said voltage switching means assuming a conductive state when a voltage of a predetermined potential or more is applied thereto, and means for connecting said first transistor and said voltage switching means in series between the power voltage terminal and said second input terminal thereby to allow said voltage switching means to assume conductive state when said second input terminal is supplied with a voltage which is higher than said power voltage by said predetermined potential or more.

2. The integrated circuit according to claim 1, char**acterized** in that said integrated circuit includes a memory circuit and said first circuit means includes a refresh control circuit for performing refresh operation of said memory.

3. The integrated circuit according to claim 1, **characterized** in that said applying means includes a capacitor (C21) having a first end receiving said internal signal and a second end coupled to the control electrode of said first transistor.

## Revendications

1. Circuit intégré à semi-conducteur mis en oeuvre avec une tension d'alimentation ($V_{cc}$) et une tension de masse (MASSE) et comprenant une puce semi-conductrice (1), des premier (109, 112, 114, 115), second (102, 105) et troisième (106) moyens de circuit formés sur la puce semi-conductrice, une multitude de bornes externes comportant une borne de tension d'alimentation recevant la tension d'alimentation ($V_{cc}$), une première borne d'entrée recevant un premier signal ($\overline{RESH}$), une seconde borne d'entrée recevant un second signal ($\overline{WE}$) et une borne de sortie ($D_{OUT}$), et un quatrième moyen de circuit (107) sensible au second signal ($\overline{WE}$) pour commander les second et troisième moyens de circuit, le premier moyen de circuit recevant le premier signal ($\overline{RESH}$) et produisant un signal interne ($\phi_R$), le second moyen de circuit recevant le signal interne et ayant une extrémité de sortie (DATA OUT) couplée à la borne de sortie, le quatrième moyen de circuit validant le second moyen de circuit et invalidant le troisième moyen de circuit lorsqu'un niveau du second signal ($\overline{WE}$) est proche de la tension d'alimentation et validant le troisième moyen de circuit et invalidant le second moyen de circuit lorsque le niveau du second signal est proche de la tension de masse, caractérisé en ce que le circuit intégré à semi-conducteur comprend de plus un circuit de détection (10) pour détecter le signal interne, le circuit de détection étant couplé entre la borne de tension d'alimentation ($V_{cc}$) et la seconde borne d'entrée ($\overline{WE}$) et comportant un premier transistor ($Q_{12}$) comportant une électrode de commande, un moyen pour appliquer le signal interne à l'électrode de commande, un moyen de commutation de tension ($Q_{11}$, $Q_{21}$ à $Q_{23}$), le moyen de commutation de tension prenant un état conducteur lorsqu'une tension d'un potentiel prédéterminé ou plus est appliquée à celui-ci et un moyen pour connecter le premier transistor et le moyen de commutation de tension en série entre la borne de tension d'alimentation et la seconde borne d'entrée pour permettre de ce fait au moyen de commutation de tension de prendre un état conducteur lorsque la seconde borne d'entrée est alimentée avec une tension qui est supérieure à la tension d'alimentation par le potentiel prédéterminé ou plus.

**2.** Circuit intégré selon la revendication 1, caractérisé en ce que le circuit intégré comporte un circuit mémoire et le premier moyen de circuit comporte un circuit de commande de régénération pour effectuer l'opération de régénération de la mémoire.

**3.** Circuit intégré selon la revendication 1, caractérisé en ce que le moyen d'application comporte un condensateur ($C_{21}$) comportant une première extrémité recevant le signal interne et une seconde extrémité couplée à l'électrode de commande du premier transistor.

**Patentansprüche**

**1.** Integrierte Halbleiterschaltung, die mit einer Netzspannung (Vcc) und einer Massespannung (GND) betriebsfähig ist und einen Halbleiterchip (1), eine erste (109, 112, 114, 115), eine zweite 102, 105) und eine dritte (106) auf dem Halbleiterchip ausgebildete Schaltung, eine Anzahl externer Anschlüsse, die einen Netzspannungsanschluß zum Empfangen der Netzspannung (Vcc), einen ersten Eingangsanschluß, der ein erstes Signal ($\overline{RESH}$) empfängt, einen zweiten Eingangsanschluß, der ein zweites Signal ($\overline{WE}$) empfängt, und einen Ausgangsanschluß (DOUT) beinhalten, und eine vierte Schaltung (107), die auf das zweite Signal ($\overline{WE}$) zum Steuern der zweiten und der dritten Schaltung anspricht, aufweist, wobei die erste Schaltung das erste Signal ($\overline{RESH}$) empfängt und ein internes Signal ($\phi_R$) erzeugt, die zweite Schaltung das interne Signal empfängt und ein Ausgangsende (DATA OUT), das mit dem Ausgangsanschluß gekoppelt ist, aufweist, die vierte Schaltung die zweite Schaltung einschaltet und die dritte Schaltung ausschaltet, wenn der Pegel des zweiten Signals ($\overline{WE}$) sich der Netzspannung annähert, und die dritte Schaltung einschaltet und die zweite Schaltung ausschaltet, wenn der Pegel des zweiten Signals sich der Massespannung annähert, dadurch **gekennzeichnet**, daß ferner eine Detektierschaltung (10) zum Erfassen des internen Signals vorgesehen ist, wobei die Detektierschaltung zwischen dem Netzspannungsanschluß (Vcc) und den zweiten Eingangsanschluß ($\overline{WE}$) gekoppelt ist und einen ersten Transistor (Q12) mit einer Steuerelektrode, Mittel zum Anlegen des internen Signals an die Steuerelektrode, Spannungsschaltelemente (Q11, Q21-Q23), wobei die Spannungsschaltelemente einen leitfähigen Zustand annehmen, wenn eine Spannung eines festgelegten Potentials oder mehr darauf aufgebracht wird, und Mittel zum Verbinden des ersten Transistors und der Spannungsschaltelemente seriell zwischen dem Netzspannungsanschluß und dem zweiten Eingangsanschluß aufweist, um dadurch den Spannungsschaltelementen zu ermöglichen, den leitfähigen Zustand anzunehmen, wenn der zweite Eingangsanschluß mit einer Spannung versorgt wird, die um das festgelegte oder Potential mehr höher als die Netzspannung ist.

**2.** Integrierte Halbleiterschaltung nach Anspruch 1, dadurch **gekennzeichnet**, daß eine Speicherschaltung vorgesehen ist und daß die erste Schaltung eine Refresh-Steuer-Schaltung zum Durchführen eines Refresh-Betriebs des Speichers aufweist.

**3.** Integrierte Halbleiterschaltung nach Anspruch 1, dadurch **gekennzeichnet**, daß die Mittel zum Anlegen einen Kondensator (C21) mit einem ersten Anschluß zum Empfangen des internen Signals und einem zweiten Anschluß, der mit der Steuerelektrode des ersten Transistors gekoppelt ist, aufweisen.

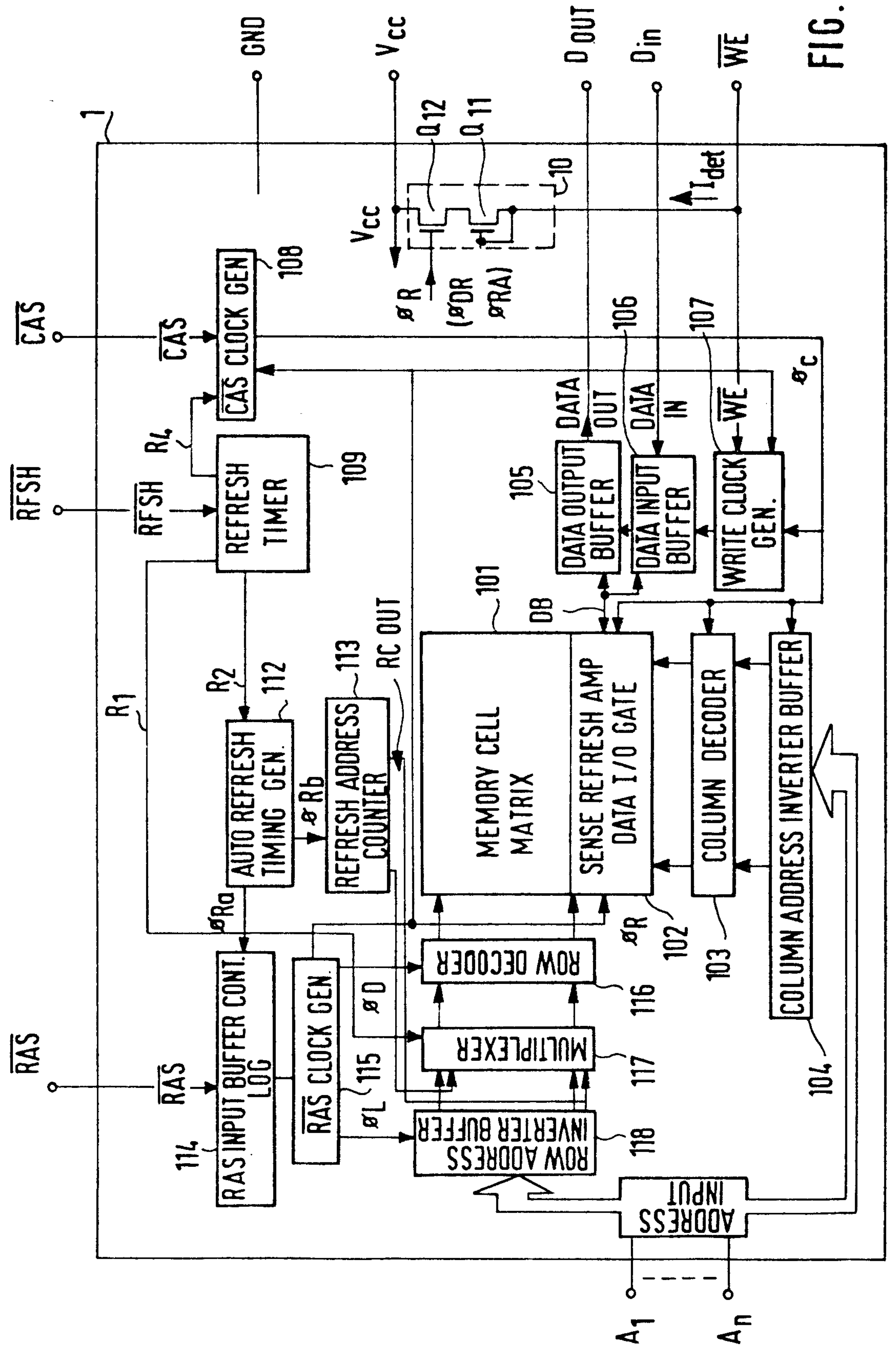
GND
Vcc
D OUT
Din
WE
CAS
RFSH
RAS
A1
An
Vcc
Q12
Q11
10
ØR
(ØDR
ØRA)
Idet
1
CAS CLOCK GEN
108
R4
REFRESH TIMER
109
DATA OUTPUT BUFFER
105
DATA OUT
DATA INPUT BUFFER
106
DATA IN
WRITE CLOCK GEN.
107
WE
ØC
DB
101
MEMORY CELL MATRIX
SENSE REFRESH AMP DATA I/O GATE
102
COLUMN DECODER
103
COLUMN ADDRESS INVERTER BUFFER
104
R2
112
AUTO REFRESH TIMING GEN.
ØRb
REFRESH ADDRESS COUNTER
113
RC OUT
R1
ØRa
RAS INPUT BUFFER CONT. LOG
114
RAS CLOCK GEN.
115
ØL
ØD
ØR
ROW DECODER
116
MULTIPLEXER
117
ROW ADDRESS INVERTER BUFFER
118
ADDRESS INPUT

FIG. 1

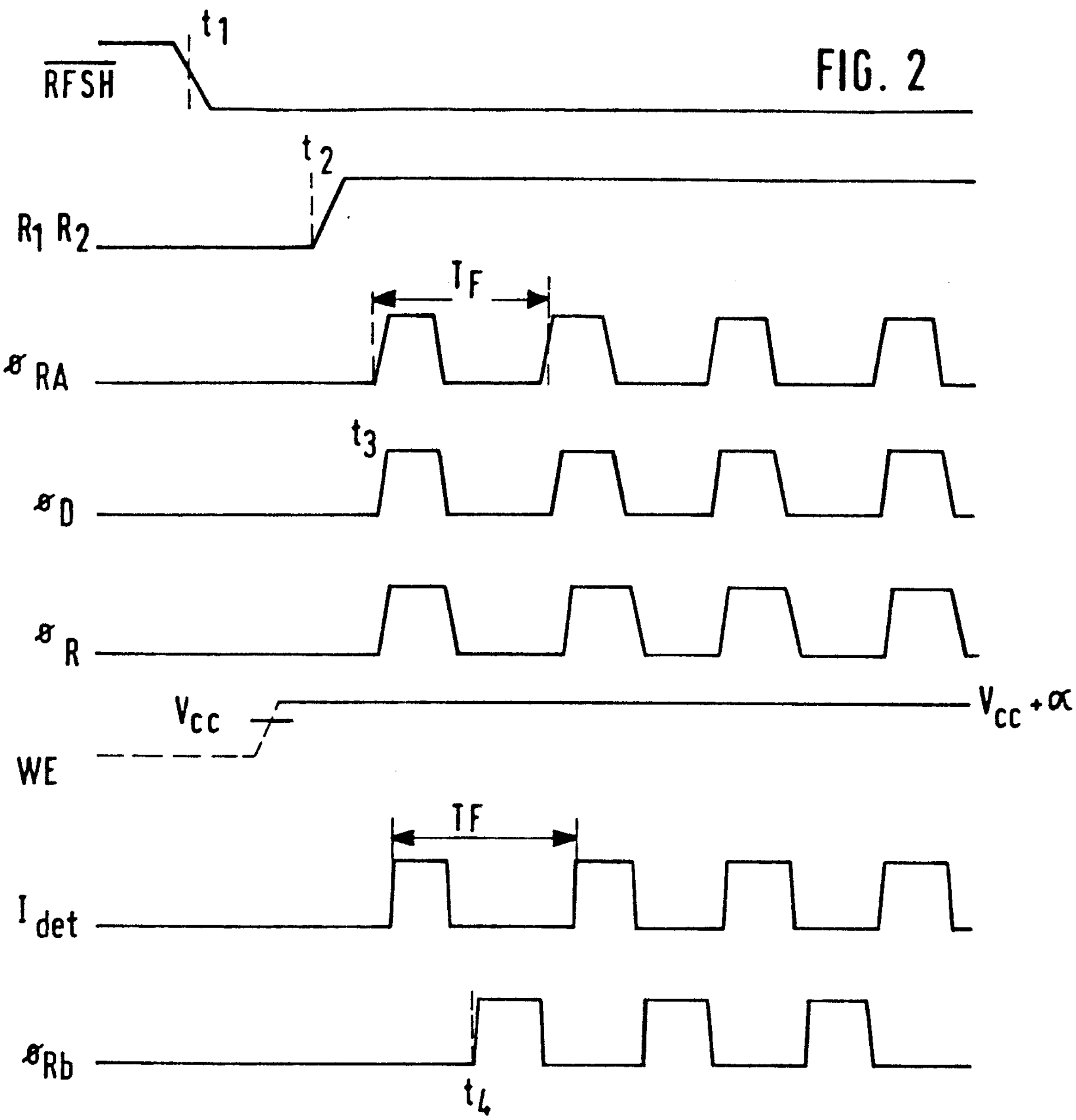


FIG. 2

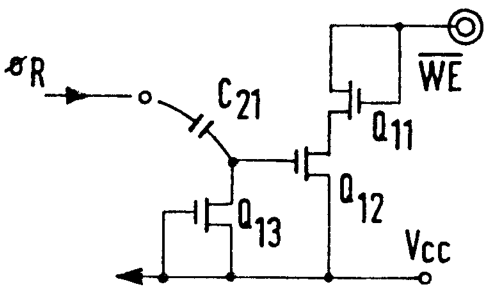


FIG. 3

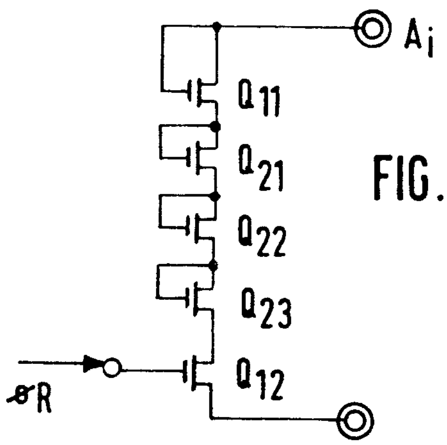


FIG. 4